(19) **Europäisches Patentamt / European Patent Office / Office européen des brevets**

(11) **EP 4 575 474 B1**

(12) **FASCICULE DE BREVET EUROPEEN**

(45) Date de publication et mention
de la délivrance du brevet:
**08.07.2026   Bulletin 2026/28**

(21) Numéro de dépôt: **24221414.6**

(22) Date de dépôt: **19.12.2024**

(51) Classification Internationale des Brevets (IPC):
**G01N 23/2055** (2018.01)       **G03F 7/00** (2006.01)

(52) Classification Coopérative des Brevets (CPC):
**G01N 23/2055; G03F 7/70633;** G01N 2223/054;
G01N 2223/611

(54) **PROCÉDÉ DE MESURE D'UN DÉFAUT DE RECOUVREMENT ; SYSTÈME INSTRUMENTAL ET PRODUIT PROGRAMME D'ORDINATEUR ASSOCIÉS**

VERFAHREN ZUR MESSUNG EINES ÜBERLAGERUNGSFEHLERS, ENTSPRECHENDES INSTRUMENTALSYSTEM UND COMPUTERPROGRAMMPRODUKT

METHOD FOR MEASURING AN OVERLAY DEFECT; ASSOCIATED INSTRUMENTAL SYSTEM AND COMPUTER PROGRAM PRODUCT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:   **19.12.2023   FR 2314490**

(43) Date de publication de la demande:
**25.06.2025   Bulletin 2025/26**

(73) Titulaire: **Commissariat à l'Energie Atomique et aux Energies Alternatives**
**75015 Paris (FR)**

(72) Inventeurs:
• **FREYCHET, Guillaume**
**38054 GRENOBLE CEDEX 9 (FR)**
• **GERGAUD, Patrice**
**38054 GRENOBLE CEDEX 9 (FR)**

(74) Mandataire: **Lavoix**
**2, place d'Estienne d'Orves**
**75441 Paris Cedex 09 (FR)**

(56) Documents cités:
**EP-A1- 4 246 135        US-A1- 2015 117 610**
**US-B2- 10 545 104**

**Description**

La présente invention concerne un procédé de mesure d'une erreur dans la superposition de deux réseaux de lignes au cours de la fabrication d'un composant microélectronique, ce procédé mettant en œuvre une technique de diffusion des rayons X aux petits angles en incidence rasante ou GISAXS (pour « grazing-incidence small-angle X-ray scattering »)

Pour poursuivre l'augmentation de la densité des éléments microélectroniques sur une faible surface, la superposition de niveaux successifs pour une intégration tridimensionnelle est en pleine expansion.

La fabrication d'un tel composant microélectronique tridimensionnel nécessite que les différents niveaux qui le constitue soient superposés avec précision, pour que les motifs portés par ces différents niveaux soient correctement positionnés les uns par rapport aux autres, de manière à garantir le bon fonctionnement du composant fabriqué.

Il est connu de contrôler la précision de la superposition de deux niveaux d'un composant en mesurant, sur une mire prévue à cette effet, une erreur d'alignement, dénommée « overlay » (en reprenant abusivement le terme anglais comme le ferait l'homme du métier), correspondant à une translation entre un premier réseau de lignes porté par un premier niveau et un second réseau de lignes porté par un second niveau du composant.

Les documents US 9 885 962 B2 ou FR 3133673 présentent un procédé de mesure de l'overlay en mettant en œuvre une technique de diffusion des rayons X par transmission ou T-SAXS. Il s'agit d'éclairer la mire portée par le composant avec un faisceau de rayons X et d'évaluer l'overlay à partir de l'intensité transmise pour différents angles d'incidence du faisceau de rayons X.

Cependant, cette technique reste difficile à mettre en œuvre puisqu'elle nécessite la transmission des rayons X à travers l'épaisseur du composant. Or ceci s'avère problématique car les différents niveaux sont déposés sur une substrat, par exemple de Silicium, présentant une épaisseur relativement importante, typiquement de $700 \mu m$.

Une mesure de l'overlay en transmission nécessite par conséquent que le faisceau de rayons X présente une intensité importante. Seules des sources synchrotrons sont susceptibles de délivrer l'intensité requise. Or de telles sources ne sont pas compatibles d'un déploiement le long d'une chaine de fabrication.

Le document US 10 545 104 B2 divulgue un système expérimental permettant, par GISAXS, d'extraire le paramètre d'overlay d'un motif constitué de la superposition de deux réseaux de lignes, en ajustant un modèle paramétrique sur l'image dans l'espace direct.

Le document US 2015/117610 A1 divulgue un procédé de détermination de l'overlay par GISAXS.

Le but de la présente invention est de proposer un procédé amélioré de mesure de l'overlay fondé sur la mise en œuvre d'une technique de diffusion des rayons X par réflexion GISAXS.

Pour cela, l'invention a pour objet un procédé de mesure, un système instrumental et un produit programme d'ordinateur selon les revendications annexées.

L'invention et ses avantages seront mieux compris à la lecture de la description détaillée qui va suivre d'un mode de réalisation particulier, donné uniquement à titre d'exemple illustratif et non limitatif, cette description étant faite en se référant aux dessins annexés sur lesquels :

La figure 1 est une représentation schématique d'un système instrumental du type GISAXS pour la mise en œuvre du procédé de mesure selon l'invention ;

La figure 2 est une image dans l'espace réciproque obtenue au moyen du système instrumental de la figure 1, pour un overlay nul entre les réseaux de lignes portés par le composant éclairé ;

La figure 3 est une image dans l'espace réciproque obtenue au moyen du système instrumental de la figure 1, pour un overlay non nul entre les réseaux de lignes portés par le composant éclairé ;

La figure 4 est un graphe superposant une pluralité de courbes de l'intensité en fonction de la coordonnée de position qz obtenues à partir de l'image de la figure 3 ;

La figure 5 est un relevé des coordonnées de position qz en fonction de l'ordre du premier minimum des courbes du graphe de la figure 4 ; et,

La figure 6 est une représentation sous forme de blocs d'un mode de réalisation du procédé de mesure de l'overlay selon l'invention

De manière générale, le procédé selon l'invention se fonde sur la mise en œuvre d'une technique de mesure par diffusion des rayons X aux petits angles en incidence rasante - GISAXS.

Dans cette technique, les rayons X ne doivent pas traverser le composant, mais sont réfléchis à sa surface.

L'intensité requise pour effectuer la mesure, c'est-à-dire pour collecter sur le détecteur d'observation une intensité suffisante pour une mesure précise, peut alors être fournie par une source de rayons X moins intense, notamment une petite source dite «de laboratoire »), comme une source Cu K-$\alpha$. Une telle source est compatible d'une intégration du système instrumental et par conséquent de la mesure de l'overlay le long d'une chaine de fabrication.

Pour pouvoir extraire l'overlay, il existe néanmoins quelques difficultés associées à cette technique, notamment les effets de multi-réflexion des rayons X à l'interface entre les différents niveaux du composant et le substrat.

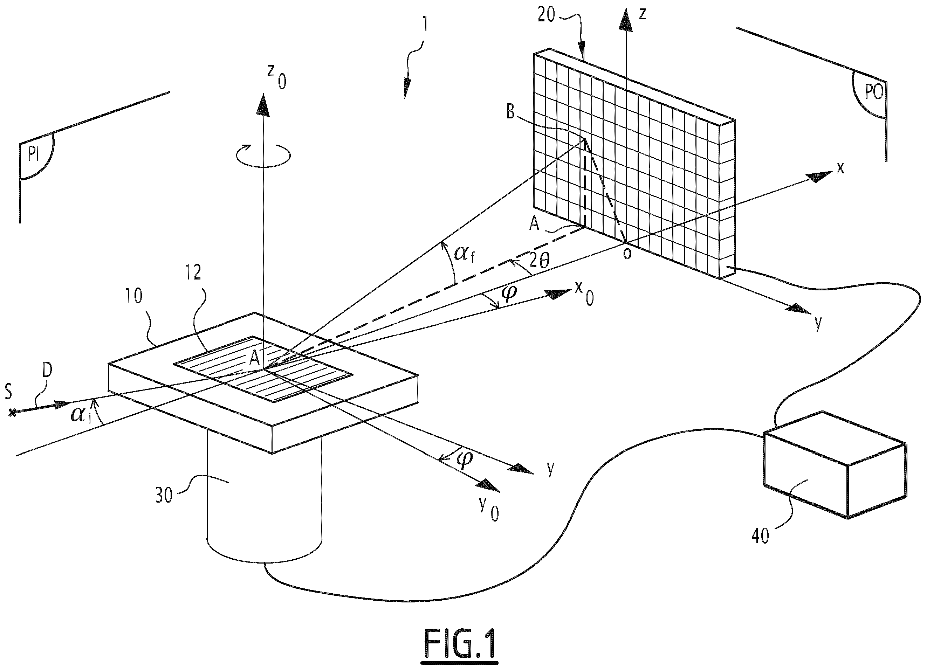

La figure 1 représente un système instrumental 1 permettant de mettre en œuvre le procédé de mesure de l'overlay selon l'invention sur un échantillon 10.

Selon cette technique, une source S éclaire l'échantillon 10 et la lumière réfléchie par l'échantillon 10 est imagée dans un plan d'observation PO.

Un repère x, y, z du système instrumental 1 est par exemple attaché à l'origine O du plan d'observation PO, de sorte que la direction normale à ce plan soit la direction x et le plan lui-même soit défini par les directions y et z.

L'échantillon 10 est par exemple un composant microélectronique sur la surface plane duquel est prévue une mire 12. La mire 12 comporte un premier niveau portant un premier réseau de ligne et un second réseau présentant un second réseau de lignes. Chaque réseau est par exemple gravé par mise en oeuvre d'un procédé de lithographie au cours de la fabrication du niveau qui le porte.

Un repère $x_0$, $y_0$, $z_0$ est attaché au centre A de la mire 12, de sorte que la direction z0 (qui correspond à la direction d'empilement des niveaux du composant 10) corresponde à la normale à la surface de l'échantillon 10, que la direction $x_0$ corresponde à la direction des lignes du réseau de lignes de la mire 12, et que la direction $y_0$ soit orthogonale aux directions $z_0$ et $x_0$, i.e. orthogonale à la direction des lignes du réseau de lignes.

L'échantillon 10 est placé sur un support 30 du système instrumental 1. De préférence et pour simplifier la présente description, l'échantillon 10 est orienté de sorte que l'axe z0 soit parallèle à l'axe z du système instrumental 1, et que le plan $x_0y_0$ de la surface de l'échantillon 10 coïncide avec le plan xy. Cependant et plus généralement, il peut exister un angle entre ces deux directions, dont il faut alors tenir compte lors de l'analyse.

La source S de rayon X émet un faisceau de rayon X selon une direction d'incidence D sur la mire 12 de l'échantillon 10.

Le plan d'incidence PI correspond au plan xz. La direction y est donc la direction normale au plan d'incidence PI.

Une mesure GISAXS s'effectue avec un angle d'incidence $\alpha_i$, entre les directions x et D, faible, par exemple de quelques radians (compris entre 0.1-10 degrés).

Le support 30 permet de faire tourner l'échantillon 10 autour de la direction $z_0$ de manière à modifier un angle d'éclairement φ entre la direction $x_0$ et la direction x, qui est également l'angle entre la direction $y_0$ et la direction y. L'angle d'éclairement φ, lorsqu'il n'est pas nul, fait qu'il y a un désalignement entre la direction des lignes du réseau de lignes (direction $x_0$) et le plan d'incidence PI.

Le faisceau incident tombe au point A de l'échantillon 10. Il est diffusé par la mire 12 de manière à former une image dans le plan d'observation PO.

Un détecteur 20 est placé dans le plan d'observation PO. Il est par exemple composé d'une matrice de capteurs de rayons X, dont les lignes sont disposées selon la direction y et les rangs selon la direction z. Chaque capteur est propre à mesurer une intensité.

L'intensité I au point B du plan d'observation PO, mesurée par le capteur localisé au point B, dépend de l'angle 2θ, défini entre la direction AO et la projection de la direction AB dans le plan xy horizontal, et de l'angle $\alpha_f$ entre la direction AB et la projection de la direction AB dans le plan xy horizontal.

Le détecteur 20 est connecté à un dispositif électronique, représenté de manière schématique sur la figure 1 par un cube portant la référence 40.

Le dispositif 40 comporte une électronique de contrôle permettant de commander le support 30 pour qu'il positionne l'échantillon 10 selon une valeur de consigne de l'angle d'éclairement φ.

Le dispositif 40 comporte également une électronique d'acquisition permettant d'effectuer des prétraitements adaptés sur les signaux délivrés par chacun des capteurs du détecteur 20 et à les numériser.

Le dispositif 40 comporte en outre un calculateur pour le traitement des signaux prétraités et numérisés. Le calculateur est un ordinateur comportant des moyens de calcul, tels qu'un processeur, et des moyens de mémorisation, tels qu'une mémoire. La mémoire stocke notamment les instructions de programmes d'ordinateur, en particulier un programme dont l'exécution permet la mise en œuvre du procédé de mesure selon l'invention.

Plutôt que d'analyser une image (collectée pour un angle d'éclairement φ particulier) dans le plan d'observation PO, c'est-à-dire dans l'espace direct des coordonnées x, y et z, il est connu de la convertir de manière à obtenir une image réciproque.

Cette image réciproque appartient à l'espace réciproque dont les coordonnées réciproques sont les fréquences spatiales $q_x$, $q_y$ et $q_z$. Les fréquences spatiales $q_x$, $q_y$ et $q_z$, respectivement associées aux directions x, y et z du repère lié au plan d'observation PO, s'écrivent :

$$q_x = \frac{2\pi}{\lambda}[\cos(\alpha_f).\cos(2\theta) - \cos(\alpha_i)] \quad (1)$$

$$q_y = \frac{2\pi}{\lambda}[\cos(\alpha_f).\sin(2\theta)] \qquad (2)$$

$$q_z = \frac{2\pi}{\lambda}[\sin(\alpha_f) + \sin(\alpha_i)] \qquad (3)$$

où $\alpha_i$ est l'angle d'incidence des rayons X sur l'échantillon, $\alpha_f$ est l'angle du rayon réfléchi hors du plan xy, $2\theta$ est l'angle de rotation autour de l'axe z0 du rayon réfléchi, et $\lambda$ est la longueur d'onde.

Sur l'image réciproque, l'information clé se trouve au niveau des tâches de Bragg (c'est-à-dire des pics de diffusion). Pour chaque angle d'éclairement $\varphi$, la tâche de Bragg d'ordre p se situe à une combinaison de valeurs ($q_y^p$, $q_z^p$) unique.

Ceci a été montré dans l'article M. Yan et al. « on the intersection of grating truncation rods with the Ewald sphere studied by grazing-incidence small-angle X-ray scattering", J. Appl. Cryst. (2007). 40, 1050-1055 :

$$q_y^p = \frac{2\pi\cos(\varphi)}{\lambda} - \frac{2\pi\sin(\alpha_i)^2\cos(\varphi)\cos(\varphi)}{\lambda} \times \left\{1 + \left[1 - \frac{\lambda^2 p^2}{b^2\sin(\alpha_i)^2\cos(\varphi)^2}\left(1 - \frac{2b\sin(\varphi)}{p\lambda}\right)\right]^{\frac{1}{2}}\right\} \qquad (4)$$

$$q_z^p = \frac{2\pi\sin(\alpha_i)\cos(\alpha_i)\cos(\varphi)}{\lambda} \times \left\{1 + \left[1 - \frac{\lambda^2 p^2}{b^2\sin(\alpha_i)^2\cos(\varphi)^2}\left(1 - \frac{2b\sin(\varphi)}{p\lambda}\right)\right]^{\frac{1}{2}}\right\} \qquad (5)$$

où $\lambda$ est la longueur d'onde des rayons X, b est la périodicité du motif, p est l'ordre du pic de diffusion, et $\alpha_i$ est l'angle d'incidence et $\varphi$ est l'angle d'éclairement.

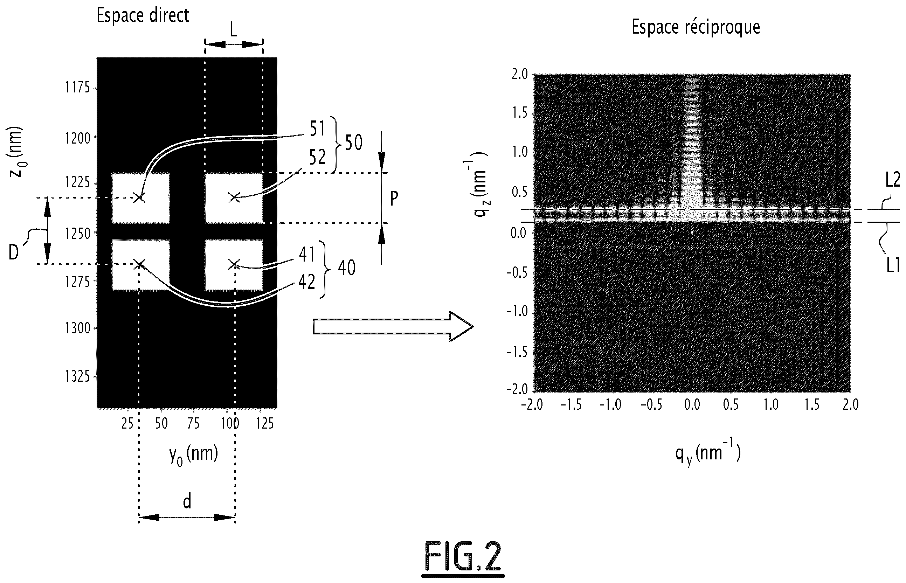

La partie de gauche de la figure 2 représente, dans l'espace direct des coordonnées y0 et z0 (ou z), une fraction du motif porté par la mire 12 du composant 10. Il s'agit de la superposition, dans l'épaisseur du composant 10 (c'est-à-dire selon la direction z0), d'un premier réseau de lignes 40 et d'un second réseau de lignes 50. Par exemple, deux lignes 41 et 42 du premier réseau et deux lignes 51 et 52 du second réseau sont représentées. Les lignes de chacun de ces réseaux s'étendent selon la direction x0, orthogonale au plan de la figure.

**Une ligne** présente une section sensiblement rectangulaire dans le plan z0y0, de largeur l et de profondeur p. Deux lignes voisines d'un même réseau de lignes sont espacées d'un pas d.

Les deux réseaux de lignes 40 et 50 sont séparés l'un de l'autre d'une distance D.

Sur la figure 2, les premier et second réseaux de lignes sont parfaitement superposés selon la direction z0.

L'éclairage en GISAXS de la configuration représentée sur la partie de gauche de la figure 2, conduit, dans l'espace réciproque $q_z$ et $q_y$ à l'image réciproque représentée sur la partie droite de la figure 2.

Plus précisément, pour obtenir cette configuration, l'angle d'incidence $\alpha_i$ est de 0.2 degré et une ligne du réseau de ligne présente une largeur et une profondeur de 40 nm. Le pas d est de 100 nm et la distance D de 40 nm, les deux réseaux de lignes étant superposés directement l'un sur l'autre.

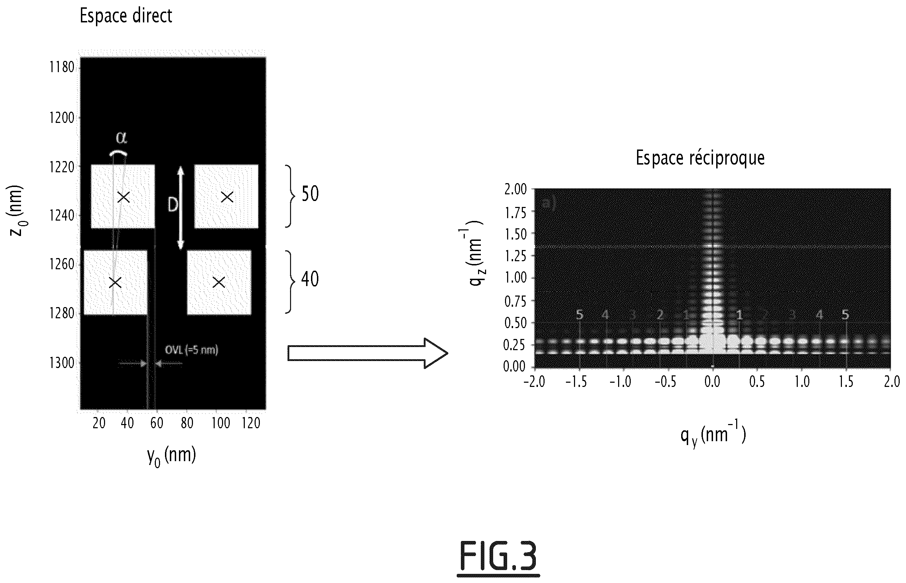

La figure 3 est similaire à la figure 2 à l'exception du fait que les premier et second réseaux de lignes 40 et 50 sont maintenant légèrement décalés l'un par rapport à l'autre selon la direction y0 d'un overlay OVL.

Les lignes du second réseau 50 sont décalées angulairement par rapport aux lignes du premier réseau 40 d'un angle a tel que :

$$tg(\alpha) = \frac{OVL}{D}$$

Soit, en première approximation, pour des valeurs de $\alpha$ petites :

$$\alpha = \frac{OVL}{D} \qquad (6)$$

Avec un tel overlay, l'image réciproque obtenue est représentée sur la partie droite de la figure 3. Il s'agit d'une représentation dans l'espace réciproque des fréquences spatiale $q_y$ et $q_z$, respectivement conjuguées des coordonnées y et z.

On constate que le signal GISAXS n'est obtenu que pour les $q_z$ positifs. En effet, les angles de sortie, $\alpha_f$, inférieurs à 0 sont masqués du détecteur par l'échantillon.

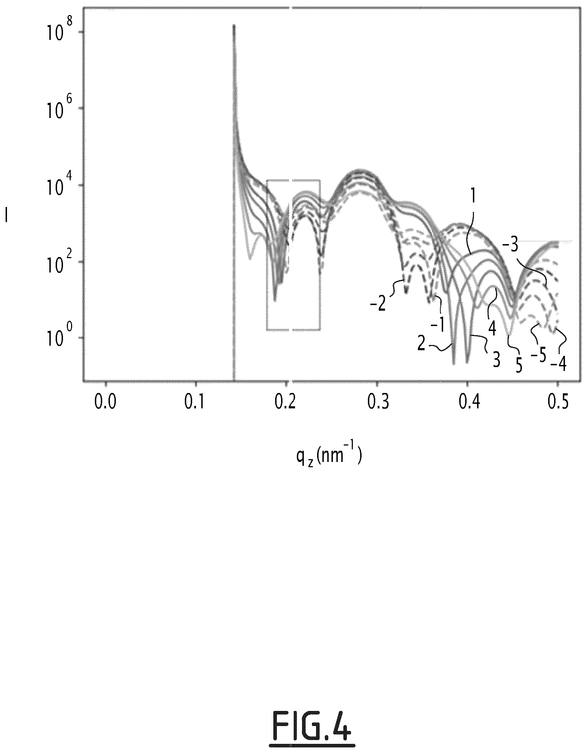

La figure 4 est un graphe superposant un ensemble de courbes donnant l'intensité I en fonction de la coordonnées $q_z$.

Chaque courbe est indexée par l'indice i, ou ordre. i est une entier relatif non nul.

Chaque courbe correspond à une coupe verticale dans l'image réciproque de la figure 3.

Chaque coupe est associée à une valeur $q_y^i$ particulière selon la direction $q_y$ de l'image réciproque de la figure 3.

Les valeurs de $q_y^i$ choisies sont réparties de manière équidistantes le long de la direction $q_y$.

Par exemple, sur la figure 3, des valeurs de $q_y^i$ retenues sont représentées pour i entier entre -5 et 5. Ces coupes verticales sont ici faites pour un pas $\Delta$ tous les 0.3 nm$^{-1}$.

Avantageusement, le pas $\Delta$ entre deux valeurs successives de $q_y^i$ est égal à la distance entre deux tiges de Bragg, mais ceci n'est pas nécessaire.

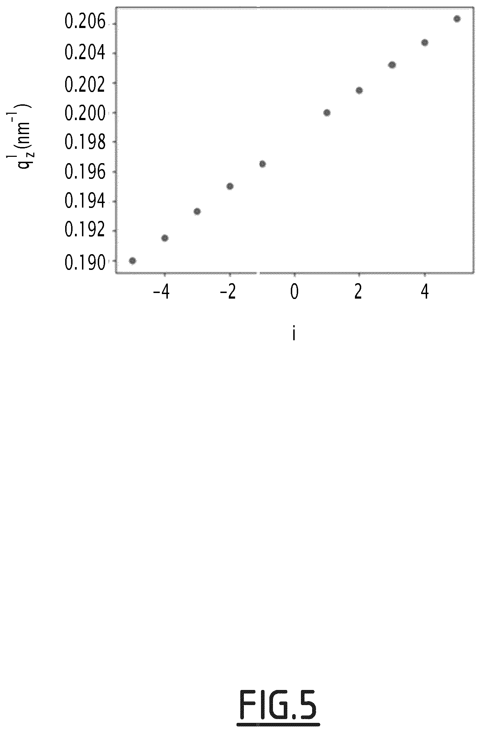

Si l'on suit l'évolution de la position $q_z^{1,i}$ selon la direction $q_z$ du premier minimum (n=1) en fonction de l'ordre i, on obtient le graphe de la figure 5.

Le graphe de la figure 5 montre une linéarité entre $q_z^{1,i}$ et i.

Une relation linéaire similaire pourrait être obtenue en suivant l'évolution de la position $q_z^{n,i}$ du nième minimum en fonction de l'ordre i, ou de tout autre point caractéristique des courbes d'intensité :

$$q_z^{n,i} = a'. \, i + b' \qquad\qquad (7)$$

L'ordre i pouvant par ailleurs être associé à une position $q_y^i$ (multiple du pas $\Delta$), on a la relation linaire générale suivante :

$$q_z^{n,i} = a. \, q_y^i + b \qquad\qquad (8)$$

Il s'agit maintenant de lier les paramètres a et b à l'overlay OVL.

Pour la région de l'image réciproque correspondant aux angle $\alpha_f$ élevés, l'effet lié aux réflexions multiple s'atténue et le cliché GISAXS devient très proche d'un cliché TSAXS. Des mesures de l'overlay peuvent être effectuées en GISAXS comme elles le sont en TSAXS.

Dans ces conditions, on montre que :

$$\tan \alpha = a = \Delta q_y / \Delta q_z \qquad\qquad (9)$$

où $\Delta q_y$ est la différence de position en $q_y$ entre deux ordres i et j ($\Delta q_y = (i - j). \, \Delta$) et $\Delta q_z$ est la différence de position en $q_z$ entre ces même deux ordres i et j ( $\Delta q_z = q_z^{n,i} - q_z^{n,j}$ ).

Cependant, pour une mesure précise aux grands angles il faut prendre en compte les multi-réflexions.

De plus, cette approche ne tire qu'un faible avantage de la configuration en éclairage rasant, puisque seuls les angles $\alpha_f$ supérieurs à trois fois l'angle d'incidence $\alpha_i$ (soit $q_z > 0.6$ nm$^{-1}$) sont considérés.

Enfin, l'intensité du signal dans cette région est faible. Il est difficilement exploitable, à moins d'augmenter le temps d'exposition, ce qui n'est pas compatible de l'intégration sur une chaine de fabrication et de la multiplication des mesures.

On cherche par conséquent à exploiter l'image dans la région proche de $\alpha_i = \alpha_f$ (angle de diffusion sensiblement égal à l'angle d'incidence), c'est-à-dire l'image réciproque pour $q_z$ compris entre 0.2 et 0.3 nm$^{-1}$, soit la partie basse, la plus intense de l'image réciproque, i.e. entre les lignes L1 et L2.

La ligne horizontale L1 est couramment appelée Yoneda et correspond à $\alpha_f$ égale à l'angle critique du substrat (ici dans cet exemple un wafer de Si), ou angle totale de réflexion. C'est dans cette gamme angulaire que les effets de multi-réflexion sont les plus intenses.

Les effets des réflexions multiples des rayons X à l'interface entre le milieu (les niveaux du composant que l'on sonde) et le substrat peuvent être pris en compte au travers une modélisation fondée sur l'approximation de Born des ondes déformées - DWBA (« Distorted Wave Born Approximation »).

Pour évaluer le signal total, on montre que quatre événements sont majoritaires et à prendre en compte pour les calculs théoriques : un premier évènement de diffusion simple à travers les niveaux du composant ; un second évènement de réflexion sur le substrat après la diffusion ; un troisième évènement de réflexion avant la diffusion ; et un quatrième évènement avec une réflexion avant la diffusion et une réflexion après la diffusion.

On établit alors théoriquement la relation suivante, qui est finalement similaire à celle utilisable dans la partie haute de l'image réciproque :

$$\tan\alpha = a = \Delta q_y / \Delta q_z \qquad\qquad (10)$$

Compte tenu de cette relation théorique, la droite joignant les points de la figure 5 permet d'extraire la valeur de l'overlay très précisément : OVL = 0.501±0.0130 nm.

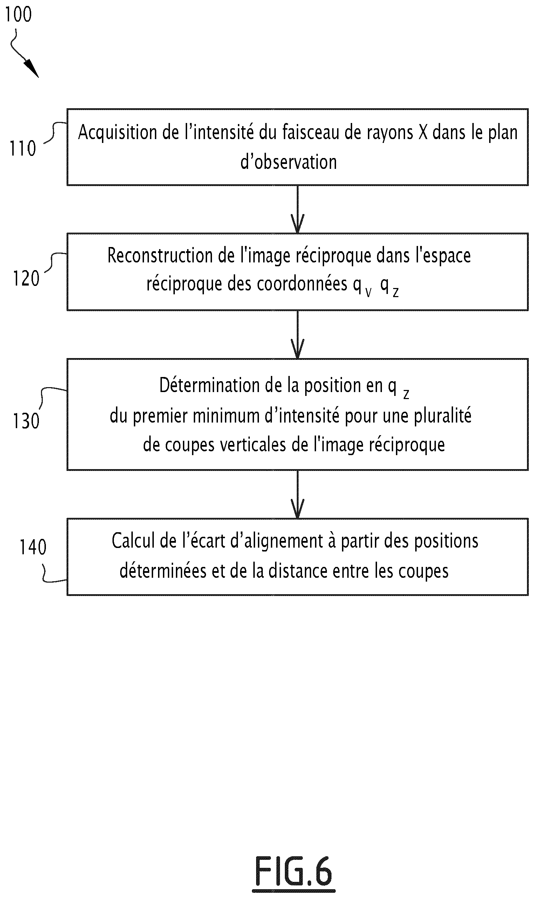

Le procédé de mesure de l'overlay selon l'invention va maintenant être présenté en référence à la figure 6.

Le procédé 100 consiste d'abord à reconstruire l'image réciproque dans l'espace réciproque.

Pour cela, dans une première étape 110 d'acquisition, au moyen du détecteur 10, on mesure l'intensité dans le plan d'observation pour une valeur de l'angle $\varphi$.

Le procédé 100 se poursuit par une seconde étape 120 consistant à reconstruire l'image réciproque dans l'espace réciproque décrit par les coordonnées $q_y$ et $q_z$.

Une fois l'image réciproque reconstruite, le procédé 100 se poursuit par une étape 130 de détermination de la position selon l'axe $q_z$ du $n^{\text{ième}}$ minimum d'intensité pour au moins deux coupes verticales de l'image réciproque obtenue à l'étape 120. De préférence, il s'agit du premier minimum puisqu'il présente un fort contraste et peut donc être localisé avec précision.

Par exemple, on mesure la position $q_z^{1,i}$ du premier minimum de la courbe d'ordre i (coupe en $q_y^i$) et la position $q_z^{1,-i}$ du premier minimum de la courbe d'ordre -i (coupe en $q_y^{-i}$).

Avantageusement, plus de deux coupes sont utilisées pour obtenir plus de points et déterminer avec une meilleure précision les coefficients de la droite reliant ces points (par exemple par une méthode de régression du type moindres carrés).

Enfin, dans une quatrième étape 140, la différence de position en $q_z$ du minimum suivi en fonction de la différence de position en $q_y$ permet d'extraire l'overlay OVL. Si l'on s'intéresse à la région la plus intense de l'image réciproque, c'est-à-dire à l'un des premiers minimum des courbes d'intensité (proche de la ligne L1) l'équation (10) est utilisée.

Avantageusement, le procédé 100 peut être itéré en modifiant l'angle d'éclairement $\varphi$.

En effet, à partir de plusieurs images collectées pour différents angles d'éclairement $\varphi$, et converties dans l'espace réciproque, une cartographie du motif peut être obtenue.

Comme l'information est contenue au niveau de la tâche de Bragg, il est donc préférable de scanner en $\varphi$, pour accéder à différents $q_y$, $q_z$, et ainsi obtenir plus d'information sur le motif.

En ne regardant que la partie autour du Yoneda, l'information sur le motif est contenue pour une faible gamme angulaire $\varphi$, entre -5 et 5°, de préférence entre -2 à 2, et de préférence encore - 0.5 et 0.5. Ces donc cette gamme s'il est alors avantageux de scanner avec précision.

Le système instrumental 1 est adapté pour mettre en œuvre le procédé de mesure 100 venant d'être présenté. En particulier, le calculateur du système 1 est convenablement programmé pour réaliser les étapes calculatoires, c'est-à-dire les étapes autres que l'étape d'acquisition, en particulier calculer l'overlay à partir de l'équation (10).

Avec le GISAXS, la géométrie en incidence rasante permet de contourner les limitations du TSAXS, puisque le faisceau de rayons X n'est plus envoyé au travers du substrat mais est réfléchi par celui.

De plus, pour ne pas se restreindre à quelques conditions de GISAXS précises, en particulier à des angles d'incidence élevés, les effets de réflexion multiples sont pris en compte.

Les mesures sont plus précises et ne dépendent pas des conditions expérimentales, puisqu'elles permettent d'extraire l'overlay même aux angles d'incidence faibles.

Cette possibilité permet d'exploiter la région intense de l'image réciproque et par conséquent autoriser des mesures avec des temps d'acquisition réduits.

## Revendications

1. Procédé (100) de mesure d'un défaut de recouvrement affectant un motif résultant de la superposition d'un premier réseau de lignes (40) porté par un premier niveau d'un composant microélectronique (10) et d'un second réseau de lignes (50) porté par un second niveau du composant microélectronique, un repère orthonormé $x_0 y_0 z_0$ étant associé au composant microélectronique, les lignes des premier et second réseaux de lignes étant orientées selon la direction $x_0$, et les premier et second réseaux de lignes étant superposés selon la direction $z_0$, le procédé de mesure mettant en oeuvre une technique de diffusion des rayons X aux petits angles par réflexion permettant d'éclairer le motif sous un angle d'incidence $\alpha_i$, le procédé comportant les étapes de :

**EP 4 575 474 B1**

- acquérir (110), au moyen d'un détecteur placé dans un plan d'observation, un repère orthonormé xyz étant associé au détecteur de sorte que l'axe z soit parallèle à l'axe $z_0$ et que l'axe x, normal au plan d'observation, coïncide avec l'axe $y_0$ pour un angle d'éclairement nulle, une pluralité de mesures d'intensité d'un faisceau de rayons X diffusé par le motif porté par le composant, l'angle d'éclairement étant défini comme l'angle, évalué dans le plan défini par des directions x et z, entre la direction x et le plan d'incidence du faisceau de rayons X ;

- reconstruire (120), à partir de la pluralité de mesures d'intensité, une image réciproque dans un espace réciproque des fréquences spatiales $q_y$ et $q_z$ associées respectivement aux directions y et z ;

- déterminer (130) au moins une première position selon la direction $q_z$ d'un point caractéristique sur une première courbe d'intensité correspondant à une première coupe de l'image réciproque pour une première valeur selon la direction $q_y$ et une seconde position selon la direction $q_z$ du point caractéristique sur une seconde courbe d'intensité correspondant à une seconde coupe de l'image réciproque dans l'espace réciproque pour une seconde valeur selon la direction $q_y$ ; et,

- calculer (140) une valeur du défaut de recouvrement à partir de l'écart entre les première et seconde positions selon la direction $q_z$ et l'écart entre les première et seconde valeurs selon la direction $q_y$ ,

**caractérisé en ce que** la valeur du défaut est mesurée en exploitant une région de l'image réciproque correspondant à un angle de diffusion sensiblement égal à l'angle d'incidence, et l'étape de calcul utilise une relation entre la mesure du défaut, d'une part, et l'écart entre les première et seconde positions selon la direction $q_z$ et l'écart entre les première et seconde valeurs selon la direction $q_y$, d'autre part, ladite relation dérivant d'une modélisation des effets de réflexions multiples des rayons X à l'interface entre les niveaux du composant et un substrat du composant.

2. Procédé selon la revendication 1, dans lequel le défaut est une translation du premier réseau de lignes par rapport au second réseau de lignes ou « overlay » (OVL).

3. Procédé selon l'une quelconque des revendications précédentes, dans lequel le point caractéristique est un minimum d'intensité, de préférence le premier minimum d'intensité.

4. Procédé selon l'une quelconque des revendications précédentes, dans lequel, pour un défaut correspondant à une translation du premier réseau de lignes par rapport au second réseau de lignes ou « overlay » , la relation est donnée par : $\tan \alpha = \Delta q_y / \Delta q_z$, où $\alpha = \dfrac{OVL}{D}$, avec OVL l'overlay, D la distance entre les premier et second réseaux de lignes, $\Delta q_z$ l'écart entre les première et seconde positions selon la direction $q_z$ et $\Delta q_y$ l'écart entre les première et seconde positions selon la direction $q_y$ .

5. Système instrumental (1) du type par diffusion des rayons X aux petits angles par réflexion (GI-SAXS), comportant une source de rayons X, un détecteur, une électronique d'acquisition et un calculateur, programmé pour la mise en œuvre d'un procédé de mesure selon l'une quelconque des revendications précédentes.

6. Système instrumental selon la revendication 5, dans lequel la source de rayons X est une source dite de laboratoire, de préférence de cuivre.

7. Produit programme d'ordinateur comportant des instructions logicielles qui, lorsqu'elles sont exécutées par un calculateur d'un système instrumental conforme à la revendication 5 ou à la revendication 6, permet à ce dernier de mettre en œuvre un procédé selon l'une quelconque des revendications 1 à 4.

**Patentansprüche**

1. Verfahren (100) zur Messung eines Abdeckungsfehlers, der ein Muster beeinflusst, das aus der Überlagerung eines ersten Liniennetzes (40), das von einer ersten Ebene einer mikroelektronischen Komponente (10) getragen wird, und eines zweiten Liniennetzes (50), das von einer zweiten Ebene der mikroelektronischen Komponente getragen wird, resultiert, wobei ein orthonormales Koordinatensystem $x_0 y_0 z_0$ mit der mikroelektronischen Komponente assoziiert ist, wobei die Linien des ersten und des zweiten Liniennetzes in Richtung $x_0$ ausgerichtet sind und das erste und das zweite Liniennetz in Richtung $z_0$ überlagert sind, wobei das Messverfahren eine Technik einer Kleinwinkel-Röntgenstreuung unter streifendem Einfall nutzt, die es ermöglicht, das Muster unter einem Einfallswinkel $\alpha_i$ zu beleuchten, wobei das Verfahren die folgenden Schritte umfasst:

- Erfassen (110) mittels eines in einer Beobachtungsebene angeordneten Detektors, wobei ein orthonormales xyz-Koordinatensystems mit dem Detektor assoziiert ist, sodass die Achse z parallel zu der Achse $z_0$ ist, und die Achse x, die senkrecht zu der Beobachtungsebene ist, bei einem Beleuchtungswinkel gleich Null mit der Achse $y_0$ übereinstimmt, einer Vielzahl von Intensitätsmessungen eines Röntgenstrahls, der von dem Muster gestreut wird, das von der Komponente getragen wird, wobei der Beleuchtungswinkel als der Winkel definiert ist, der in der Ebene definiert durch die Richtung x und z zwischen der Richtung x und der Einfallsebene des Röntgenstrahls gemessen wird;

- Rekonstruieren (120), anhand der Vielzahl von Intensitätsmessungen, eines reziproken Bilds in einem reziproken Raum der räumlichen Frequenzen $q_y$ und $q_z$, die jeweils mit den Richtungen y und z assoziiert sind;

- Bestimmen (130) mindestens einer ersten Position gemäß der Richtung $q_z$ eines charakteristischen Punkts auf einer ersten Intensitätskurve, die einem ersten Schnitt des reziproken Bilds für einen ersten Wert in Richtung $q_y$ entspricht, und einer zweiten Position in Richtung $q_z$ des charakteristischen Punkts auf einer zweiten Intensitätskurve, die einem zweiten Schnitt des reziproken Bilds in dem reziproken Raum für einen zweiten Wert in Richtung $q_y$ entspricht; und

- Berechnen (140) eines Werts des Abdeckungsfehlers anhand der Abweichung zwischen der ersten und der zweiten Position in Richtung $q_z$ und der Abweichung zwischen dem ersten und dem zweiten Wert in Richtung $q_y$,

**dadurch gekennzeichnet, dass** der Wert des Fehlers gemessen wird, indem ein Bereich des reziproken Bilds ausgewertet wird, der einem Streuwinkel entspricht, der im Wesentlichen gleich wie der Einfallswinkel ist, und der Berechnungsschritt eine Beziehung zwischen der Messung des Fehlers und der Abweichung zwischen der ersten und der zweiten Position in Richtung $q_z$ und der Abweichung zwischen dem ersten und dem zweiten Wert in Richtung $q_y$ verwendet, wobei sich diese Beziehung aus einer Modellierung der Mehrfachreflexionseffekte der Röntgenstrahlen an der Grenzfläche zwischen den Schichten der Komponente und einem Substrat der Komponente ableitet.

2. Verfahren nach Anspruch 1, wobei der Fehler eine Verschiebung des ersten Liniengitters in Bezug auf ein zweites Liniengitter oder "Overlay" (OVL) ist.

3. Verfahren nach einem der vorherigen Ansprüche, wobei der charakteristische Punkt ein Intensitätsminimum, vorzugsweise das erste Intensitätsminimum, ist.

4. Verfahren nach einem der vorherigen Ansprüche, wobei für einen Fehler, der einer Verschiebung des ersten Liniengitters in Bezug auf das zweite Liniengitter oder einem "Overlay" entspricht, die Beziehung gegeben ist durch:

$\tan \alpha = \Delta q_y / \Delta q_z$, wobei $\alpha = \dfrac{OVL}{D}$ , wobei OVL das Overlay ist; D der Abstand zwischen dem ersten und dem zweiten Liniengitter ist, $\Delta q_z$ die Abweichung zwischen der ersten und der zweiten Position in Richtung $q_z$ und $\Delta q_y$ ist, die Abweichung zwischen der ersten und der zweiten Position in Richtung $q_y$ ist.

5. Messsystem (1) vom Typ Kleinwinkel-Röntgenstreuung unter streifendem Einfall (GI-SAXS) ist, umfassend eine Röntgenquelle, einen Detektor, eine Erfassungselektronik und einen Rechner, der zum Implementieren eines Messverfahrens nach einem der vorherigen Ansprüche programmiert ist.

6. Messsystem nach Anspruch 5, wobei die Röntgenquelle eine sogenannte Laborquelle, vorzugsweise aus Kupfer, ist.

7. Computerprogramm, umfassend Softwareanweisungen, die, wenn sie von einem Rechner eines Instrumentensystems nach Anspruch 5 oder Anspruch 6 ausgeführt werden, diesem ermöglichen, ein Verfahren nach einem der Ansprüche 1 bis 4 durchzuführen.

## Claims

1. A method (100) for measuring an overlay defect affecting a pattern resulting from the superposition of a first line grating (40) carried by a first level of a microelectronic component (10) and of a second line grating (50) carried by a second level of the microelectronic component, an orthonormal reference frame $x_0 y_0 z_0$ being associated with the microelectronic component, the lines of the first and second line gratings being oriented according to the direction $x_o$, and the first and second line gratings being superposed according to the direction $z_o$, the method for measuring implementing a grazing-incidence small-angle X-ray scattering by reflection technique allowing to illuminate the pattern under an angle of incidence $\alpha_i$, the method including the steps of:

- acquiring (110), by means of a detector placed in an observation plane, an orthonormal reference frame xyz being associated with the detector so that the axis z is parallel to the axis $z_o$ and that the x axis, normal to the observation plane, coincides with the $y_o$ axis for a zero illumination angle, a plurality of intensity measurements of an X-ray beam scattered by the pattern carried by the component, the illumination angle being defined as the angle, evaluated in the plane defined by the directions x and z, between the x and the plane of incidence of the X-ray beam;

- reconstructing (120), from the plurality of intensity measurements, a reciprocal image in a reciprocal space of spatial frequencies $q_y$ and $q_z$ associated respectively with directions y and z:

- determining (130) at least a first position according to the direction $q_z$ of a characteristic point on a first intensity curve corresponding to a first cross-section of the reciprocal image for a first value according to the direction $q_y$ and a second position according to the direction $q_z$ of the characteristic point on a second intensity curve corresponding to a second cross-section of the reciprocal image in the reciprocal space for a second value according to the direction $q_y$; and,

- calculating (140) a value of the overlay defect from the difference between the first and second positions according to the direction $q_z$ and the difference between the first and second values according to the direction $q_y$.

**characterized in that** the defect value is measured by exploiting a region of the reciprocal image corresponding to a scattering angle substantially equal to the angle of incidence, and the calculating step uses a relationship between the defect measurement, on the one hand, and the difference between the first and second positions according to the direction $q_z$, and the difference between the first and second values according to the direction $q_y$, on the other hand, said relationship being derived from a modelling of the effects of multiple reflections of the X-rays at the interface between the levels of the component and a substrate of the component.

2. The method according to claim 1, wherein the defect is a translation of the first line grating relative to the second line grating or "overlay" (OVL).

3. The method according to any one of the preceding claims, wherein the characteristic point is an intensity minimum, preferably the first intensity minimum.

4. The method according to any one of the preceding claims, wherein, for a defect corresponding to a translation of the first line grating relative to the second line grating or "overlay", the relationship is given by: $\tan \alpha = \Delta q_y / \Delta q_z$ where $\alpha = \dfrac{OVL}{D}$, with OVL the overlay, D the distance between the first and second line gratings, $\Delta q_z$, the difference between the first and second positions according to the direction $q_z$ and $\Delta q_y$ the difference between the first and second positions according to the direction $q_y$.

5. An instrumental system (1) of the grazing-incidence small-angle X-ray scattering by reflection (GI-SAXS) type, including an X-ray source, a detector, acquisition electronics and a computer, programmed for the implementation, of a method for measuring according to any one of the preceding claims.

6. The instrumental system according to claim 5, wherein the X-ray source is a so-called laboratory source, preferably copper.

7. A computer program product including software instructions which, when executed by a computer of an instrumental system in accordance with claim 5 or claim 6, allows it to implement a method according to any one of claims 1 to 4. .

EP 4 575 474 B1

FIG.1

Espace direct

Espace réciproque

## FIG.2

Espace direct

Espace réciproque

FIG.3

## FIG.4

**FIG.5**

100

110 — Acquisition de l'intensité du faisceau de rayons X dans le plan d'observation

120 — Reconstruction de l'image réciproque dans l'espace réciproque des coordonnées $q_v$ $q_z$

130 — Détermination de la position en $q_z$ du premier minimum d'intensité pour une pluralité de coupes verticales de l'image réciproque

140 — Calcul de l'écart d'alignement à partir des positions déterminées et de la distance entre les coupes

# FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 9885962 B2
- FR 3133673
- US 10545104 B2
- US 2015117610 A1

**Littérature non-brevet citée dans la description**

- **M. YAN et al.** on the intersection of grating truncation rods with the Ewald sphere studied by grazing-incidence small-angle X-ray scattering. *J. Appl. Cryst.*, 2007, vol. 40, 1050-1055